(19) Europäisches Patentamt / European Patent Office / Office européen des brevets

(11) **EP 4 498 608 A1**

(12) **DEMANDE DE BREVET EUROPEEN**

(43) Date de publication:
**29.01.2025 Bulletin 2025/05**

(21) Numéro de dépôt: **23306274.4**

(22) Date de dépôt: **24.07.2023**

(51) Classification Internationale des Brevets (IPC):
*H04B 1/04* (2006.01)

(52) Classification Coopérative des Brevets (CPC):
**H04B 1/04;** H04B 2001/0408

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**KH MA MD TN**

(71) Demandeur: **BULL SAS**
**78340 Les Clayes-Sous-Bois (FR)**

(72) Inventeur: **TENEZE, Bernard**
**13640 La Roque-d'Anthéron (FR)**

(74) Mandataire: **IPAZ**
**Bâtiment Platon**
**Parc Les Algorithmes**
**91190 Saint-Aubin (FR)**

(54) **RADIO LOGICIELLE EQUIPÉE D'UNE PROTECTION DE SON AMPLIFICATEUR DE PUISSANCE**

(57) L'invention concerne une radio logicielle (200) comprenant :
- au moins un processeur (104) produisant un signal numérique,
- un convertisseur numérique-analogique, CNA, (106) pour convertir ledit signal numérique en un signal analogique,
- une interface physique (110) entre le processeur (104) et le CNA, et
- un amplificateur de puissance radiofréquence (108) pour amplifier la puissance dudit signal analogique ;
ladite radio logicielle (200) comprenant en outre, agencée dans ladite interface physique (110), une unité (202) de protection dudit amplificateur de puissance (108) en fonction :
- de la puissance moyenne, sur une durée de référence prédéfinie, du signal numérique reçu par ladite interface physique (110),
- d'un seuil de puissance prédéfini à ne pas dépasser pendant ladite durée.
Elle concerne également un appareil électronique comprenant une telle radio numérique et un procédé de protection d'une radio logicielle.

**FIG. 2**

EP 4 498 608 A1

**Description**

La présente invention concerne une radio logicielle équipée d'une protection de son amplificateur de puissance. Elle concerne également un appareil électronique comprenant une telle radio numérique. Elle concerne en outre un procédé de protection d'une radio logicielle.

Le domaine de l'invention est le domaine des radios logicielles, également appelées radio SDR (pour « Software Defined Radio » en anglais),et en particulier les radios logicielles émettrices ou émettrices-réceptrices. En particulier, l'invention concerne la protection de l'amplificateur de puissance d'une radio SDR.

## État de la technique

Une radio logicielle, ou SDR, comporte généralement un CPU exécutant un logiciel qui fournit un flux de données numériques à émettre. Le flux de données numériques, également appelé signal numérique dans la suite, est converti en un signal analogique dans un convertisseur numérique-analogique, CNA. Le signal analogique est fourni à un amplificateur de puissance radiofréquence qui amplifie ledit signal analogique pour qu'il puisse être transmis dans les airs grâce à une antenne d'émission. La radio logicielle comporte en outre une interface physique entre le CPU et le CNA : cette interface physique peut être un FPGA ou un ASIC par exemple.

Un amplificateur de puissance radiofréquence peut être dégradé lorsque la puissance du signal analogique qui lui est fourni en entrée dépasse un seuil limite de puissance pendant une durée donnée. Dans certaines applications, telles que par exemple les applications 4G ou 5G, la puissance instantanée du signal analogique à amplifier peut dépasser le seuil limite de puissance, mais seulement pendant des durées très courtes, ce qui ne constitue pas de danger pour l'amplificateur de puissance. Mais en cas d'erreurs, par exemple en cas de bugs ou de dysfonctionnements, il se peut que le seuil limite de puissance soit dépassé pendant une période supérieure à la durée donnée, abîmant ainsi l'amplificateur de puissance.

Pour faire face à cette problématique, une solution est de surveiller le courant consommé par l'amplificateur de puissance : si le courant consommé dépasse un seuil prédéterminé, alors l'alimentation électrique de l'amplificateur est coupée. Cette solution nécessite l'ajout de composants physiques supplémentaires à la radio logicielle, ce qui augmente le coût et la complexité de la radio logicielle. De plus, elle nécessite l'intégration d'une fonction spécifique pour les applications nécessitant de dépasser ponctuellement le seuil limite de puissance : ce qui augmente sa complexité. Enfin, elle n'est pas facilement adaptable aux évolutions des signaux à traiter ou des amplificateurs de puissance utilisés.

Un but de la présente invention est de remédier à au moins un des inconvénients précités.

Un autre but de la présente invention est de proposer une radio logicielle comprenant une solution de protection de l'amplificateur de puissance plus simple et moins coûteuse.

Un autre but de la présente invention est de proposer une radio logicielle comprenant une solution de protection de l'amplificateur de puissance plus flexible et plus adaptable, aux évolutions des signaux à traiter et/ou des amplificateurs de puissance utilisés.

## Exposé de l'invention

L'invention propose d'atteindre au moins l'un des buts précités par une radio logicielle comprenant :

-    au moins un processeur exécutant un logiciel produisant un signal numérique représentant un flux de données à émettre,
-    un convertisseur numérique-analogique, CNA, pour convertir ledit signal numérique en un signal analogique,
-    une interface physique entre ledit au moins un processeur et ledit CNA, et
-    un amplificateur de puissance radiofréquence pour amplifier la puissance dudit signal analogique.

Selon l'invention, la radio logicielle comprend en outre, agencée dans ladite interface physique, une unité de protection dudit amplificateur de puissance en fonction :

-    de la puissance moyenne, sur une durée de référence prédéfinie, du signal numérique reçu par ladite interface physique,
-    d'un seuil de puissance prédéfini à ne pas dépasser pendant ladite durée.

En d'autres termes, l'unité de protection de l'amplificateur est intégrée dans l'interface physique de la radio logicielle. Cette unité de protection a pour fonction d'éviter que l'amplificateur de puissance radiofréquence ne reçoit un signal dont la puissance moyenne sur la durée de référence dépasse le seuil de puissance, ce qui pourrait causer une dégradation dudit amplificateur.

Ainsi, l'invention propose une radio logicielle comportant une fonction de protection de l'amplificateur de puissance radiofréquence, également appelée amplificateur de puissance ou amplificateur dans la suite, qui est directement intégrée dans un composant physique de la radio logicielle et qui ne nécessite pas l'ajout de composants additionnels, en plus des composants formant la radio logicielle. L'invention propose donc une solution de protection de l'amplificateur de la radio logicielle plus simple et moins coûteuse.

De plus, la solution de protection de la radio logicielle selon l'invention intégrée dans l'interface physique se présente sous une forme logicielle, ou sous la forme d'une configuration modifiable d'un composant matériel, ce qui constitue une solution de protection plus flexible et plus adaptable aux évolutions dans les signaux à traiter et/ou dans les amplificateurs de puissance utilisés. L'adaptation de la solution de protection proposée par la présente invention à une évolution du signal à traiter, et/ou de l'amplificateur de puissance utilisé, ne nécessite pas de changement matériel, ce qui est plus aisé et rend la solution de protection plus flexible.

En outre, la solution de protection de la radio logicielle selon l'invention se base sur une puissance moyenne du signal numérique fourni par le processeur, et non sur la puissance instantanée dudit signal, ce qui permet son utilisation dans les applications, de type 4G ou 5G, dans lesquelles la puissance instantanée du signal peut, de manière ponctuelle, dépasser le seuil limite de puissance.

Dans le présent document, par « radio logicielle » on entend un émetteur radiofréquence logiciel, ou un émetteur-récepteur radiofréquence logiciel.

Suivant des modes de réalisation, l'unité de protection peut comprendre :

- un module de calcul de la puissance moyenne, sur la durée de référence, du signal numérique reçu par l'interface physique,
- un comparateur comparant ladite puissance moyenne calculée au seuil de puissance, et
- un étage de modification de la puissance instantanée du signal numérique fourni au CNA, lorsque ladite puissance moyenne atteint ledit seuil de puissance.

Suivant des alternatives, le module de calcul de la puissance instantanée, et/ou le comparateur, peut se trouver dans d'autres composants de la radio logicielle, par exemple dans le processeur qui fournit le signal numérique. Cette information peut être fournie à l'interface physique en même temps que le signal numérique.

L'étage de modification de la puissance instantanée peut être configurée pour modifier, et en particulier diminuer, la puissance instantanée du signal numérique, pendant une durée, appelée durée de temporisation. Cette durée de temporisation peut être prédéterminée. Par exemple, et sans perte de généralité, la durée de temporisation peut être égale à la durée de référence.

Suivant des modes de réalisation, l'étage de modification peut comprendre un moyen arrêtant la fourniture du signal numérique au CNA.

Dans ce cas, lorsque la puissance moyenne sur la durée de référence, atteint ou dépasse le seuil de puissance, le signal numérique reçu du processeur n'est plus transmis au CNA. Autrement dit, la radio logicielle n'émet plus de signal.

Bien entendu, ce mode de réalisation est un mode dégradé car il provoque l'arrêt de la radio logicielle.

Suivant des modes de réalisation, l'étage de modification peut comprendre un réducteur pour réduire la puissance du signal numérique reçu en entrée de l'interface physique.

Dans ce cas, l'interface physique continue de transmettre le signal numérique vers le CNA, après avoir diminué la puissance instantanée dudit signal.

La réduction de la puissance instantanée du signal numérique peut en particulier être réalisée par application, audit signal numérique, d'un gain inférieur à 1.

La valeur du gain appliqué par le réducteur dépend de la puissance instantanée du signal numérique et du seuil de puissance.

Suivant un exemple de réalisation non limitatif, la valeur du gain peut être calculée selon la relation suivante :

$$\text{Gain} = (\text{seuil de puissance})/(\text{maximum de la puissance instantanée})$$

L'interface physique peut être, ou peut comprendre, tout type composant physique programmable.

Suivant des modes de réalisation, l'interface physique peut comprendre, ou peut être, un FPGA (« Field-programmable gate array » ou « Réseau de portes programmables in situ ») ou ASIC (« Application Specific Integrated Circuit »).

Suivant un autre aspect de la même invention, il est proposé un appareil électronique comprenant une radio logicielle selon l'invention.

L'appareil électronique peut être tout type d'appareil, en particulier radiofréquence prévu pour émettre, ou émettant, un signal radiofréquence, et en particulier un signal radiofréquence représentant des données.

Suivant des exemples de réalisation non limitatifs, l'appareil selon l'invention peut être :

- un émetteur Wifi,
- un émetteur Bluetooth®,
- un émetteur radio numérique terrestre (DAB pour « Digital Audio Broadcasting »),
- un émetteur radio numérique mobile (DMR pour « Digital Mobile radio »),
- etc.

Suivant un autre aspect de la même invention, il est proposé un procédé de protection d'une radio logicielle, ladite radio logicielle comprenant :

- au moins un processeur exécutant un logiciel produisant un signal numérique représentant un flux de données à émettre,
- un convertisseur numérique-analogique, CNA, pour convertir ledit signal numérique en un signal analogique,
- une interface physique entre ledit au moins un processeur et ledit CNA, et
- un amplificateur de puissance radiofréquence pour amplifier la puissance dudit signal analogique fourni par le CNA ;

ledit procédé comprenant une exécution, au sein de ladite interface physique, d'une fonction de protection dudit amplificateur de puissance comprenant les étapes suivantes :

- calcul de la puissance moyenne, sur une durée de référence prédéfinie, du signal numérique reçu par ladite interface physique,
- comparaison de ladite puissance à un seuil de puissance prédéfini à ne pas dépasser pendant ladite durée de référence, et
- lorsque ladite puissance moyenne atteint le seuil de puissance limite, diminution de la puissance instantanée dudit signal numérique fourni au CNA.

Le procédé selon l'invention fournit les mêmes avantages que ceux décrits plus haut en référence à la radio logicielle selon l'invention.

En particulier, l'étape de diminution de la puissance instantanée peut être réalisée pendant une durée prédéterminée, dite durée de temporisation.

Ainsi, le procédé selon l'invention permet de diminuer la puissance moyenne du signal fourni au CNA, et donc à l'amplificateur de puissance.

L'étape de diminution de la puissance instantanée peut être réalisée de plusieurs façons.

En particulier, l'étape de diminution de la puissance instantanée peut être réalisée par application d'un gain inférieur à 1 au signal numérique reçu en entrée de l'interface physique.

De manière générale, le procédé selon l'invention peut comprendre en termes de fonction, et/ou d'étape, chacune des caractéristiques optionnelles décrites plus haut en référence à la radio logicielle et qui ne sont pas reprises ici en détail par soucis de concision.

### Description des figures et modes de réalisation

D'autres avantages et caractéristiques apparaîtront à l'examen de la description détaillée de modes de réalisation nullement limitatifs, et des dessins annexés sur lesquels :

- la FIGURE 1 est une représentation schématique d'un exemple de réalisation d'une radio logicielle de l'art antérieur ;
- la FIGURE 2 est une représentation schématique d'un exemple de réalisation non limitatif d'une radio logicielle selon l'invention ;
- la FIGURE 3 est une représentation schématique d'un exemple de réalisation non limitatif d'une radio logicielle selon l'invention ; et
- la FIGURE 4 est une représentation schématique d'un exemple de réalisation non limitatif d'un procédé selon l'invention.

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détails structurels, ou avec seulement une partie des détails structurels si c'est cette partie qui est uniquement suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures et dans la suite de la description, les éléments communs à plusieurs figures conservent la même référence.

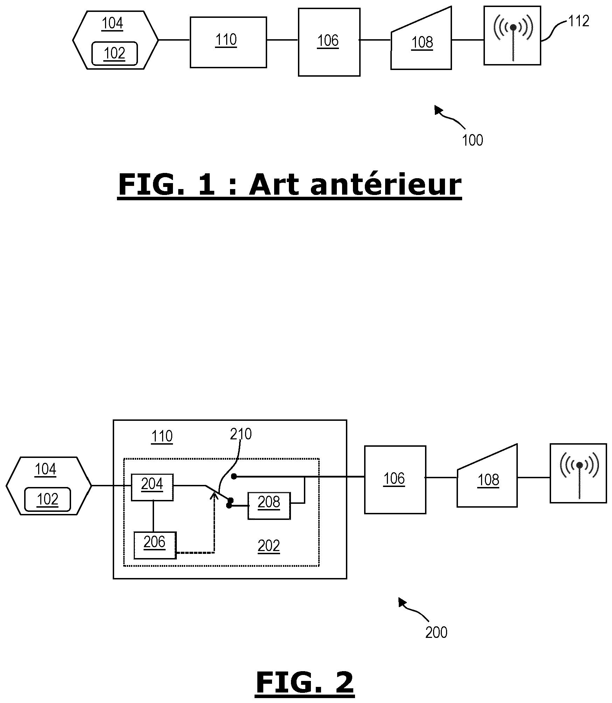

La FIGURE 1 est une représentation schématique d'une radio logicielle de l'art antérieur.

La radio logicielle 100, représentée sur la FIGURE 1, comprend un logiciel 102, ou un programme d'ordinateur, produisant des données numériques, ou un flux de données numériques, à émettre par la radio logicielle. Le logiciel peut être de tout type et les données à transmettre peuvent être de tout type. Par exemple, les données numériques peuvent être des données de communication entre un premier appareil intégrant la radio logicielle et un autre appareil comportant un récepteur radio fréquence. Les données peuvent être des données représentant de la musique, une vidéo, des données représentant le résultat d'un calcul, des données représentant le résultat de mesures d'une grandeur physique, etc.

De manière classique, le logiciel 102 est exécuté dans au moins un calculateur ou au moins un processeur, CPU, 104. Un seul CPU 104 est représenté sur la FIGURE 1, sans perte de généralité.

La radio logicielle 100 comprend en outre un convertisseur numérique-analogique, CNA, 106 pour transformer les données numériques produites dans le CPU 104, en un signal analogique.

Le signal analogique généré par le CNA 106 est ensuite transmis à un amplificateur de puissance radiofréquence 108. Ce dernier augmente la puissance du signal analogique en vue de son émission dans les airs au travers d'une antenne d'émission. L'amplificateur de puissance 108 est un composant classiquement utilisé dans les radios logicielles.

La radio logicielle 100 comprend, entre le CPU 104 et le CNA 106, un composant physique 110, réalisant l'interface physique entre le CPU 104 et le CNA 106. De manière classique, le composant 110 peut être un composant électronique programmable. Suivant des exemples non limitatifs, le composant 110 peut être un FPGA, ou un ASIC. Le composant 110 a pour rôle de faire l'interface être le CPU et le CNA et de transmettre le signal numérique produit dans le CPU vers le CNA en vue de sa conversation en un signal analogique.

Optionnellement, la radio logicielle 100 peut comprendre une antenne d'émission 112, reliée directement ou indirectement à l'amplificateur de puissance 108, pour émettre dans les airs le signal analogique amplifié fourni par l'amplificateur de puissance 108.

La radio logicielle 100 de la FIGURE 1 présente l'architecture classique d'une radio logicielle de l'état de la technique. Dans cette architecture, l'amplificateur de puissance 108 peut recevoir un signal analogique dont la puissance moyenne, sur une durée de référence donnée, peut dépasser un seuil de puissance que ledit amplificateur ne peut supporter. En pareil cas, l'amplificateur de puissance 108 peut être abîmé rendant la radio logicielle 100 non fonctionnelle. Il est alors nécessaire de procéder au remplacement de l'amplificateur de puissance 108 : ce qui suppose des opérations chronophages pour le démontage physique de l'amplificateur de puissance 108, et pour son remplacement physique.

La présente invention permet de répondre à cette problématique.

La FIGURE 2 est une représentation schématique d'un exemple de réalisation non limitatif d'une radio logicielle selon l'invention.

La radio logicielle 200, représentée sur la FIGURE 2, comprend tous les éléments de la radio logicielle 100 de la FIGURE 1.

De plus, la radio logicielle 200 comprend une unité 202 de protection de l'amplificateur de puissance 108, intégrée dans le composant 110 réalisant l'interface physique entre le CPU 104 et le CNA 106.

Cette unité de protection 202 se présente sous la forme d'un logiciel, ou d'une configuration, appliquée au composant 110 et ne nécessite pas de composants physique additionnel, de sorte que la radio logicielle 200 ne comprend pas plus de composants physique que la radio logicielle 100 de l'art antérieur.

L'unité de protection 202 a pour fonction de :

- déterminer la puissance moyenne, sur une durée de référence prédéfinie, du signal numérique reçu du CPU 104 ; et
- diminuer la puissance instantanée dudit signal numérique lorsque ladite puissance moyenne dépasse un seuil de puissance prédéfini.

Le seuil de puissance prédéfini correspond à la puissance moyenne limite que l'amplificateur de puissance 108 peut tolérer, sur la durée de référence, sans être dégradé/abîmé. Le seuil de puissance, pour une durée de référence, dépend de l'amplificateur de puissance 108. Ainsi, il est possible de définir par configuration du composant 110 ce seuil de puissance, et donc s'adapter à la fois aux évolutions du signal numérique à traiter et aux évolutions de l'amplificateur de puissance utilisé.

Dans l'exemple représenté, l'unité de protection 202 comprend un module 204 de calcul de la puissance moyenne du signal numérique entrant dans le composant 110. Pour chaque instant t, le module 204 calcule la puissance

moyenne, notée $P_m$, du signal numérique sur la fenêtre temporelle t-D, avec D la durée de référence prédéfinie.

L'unité de protection 202 comprend en outre un comparateur 206 configuré pour comparer la puissance moyenne $P_m$, au seuil de puissance, notée SP, préalablement défini pour l'amplificateur de puissance 108.

L'unité de protection 202 comprend en outre un réducteur de puissance 208. Ce réducteur de puissance 208 applique, au signal numérique reçu du CPU, un gain, noté G, de valeur inférieure à 1 pour diminuer la puissance instantanée dudit signal numérique.

L'unité de protection 202 comprend en outre un commutateur 210 déplaçable entre :

- une première position dans laquelle le signal numérique provenant du CPU n'est pas injecté dans le réducteur de puissance 208 et subit le traitement classique dans le composant 110, et
- une deuxième position dans laquelle le signal numérique provenant du CPU est injecté dans le réducteur de puissance 208 en plus du traitement classique dudit signal dans ledit composant 110.

Sur la FIGURE 2, le commutateur 210 est représenté dans la deuxième position.

Dans l'exemple représenté, le commutateur 210 est commandé par le comparateur 206. Suivant des alternatives non représentées, le commutateur 210 peut être commandé par un module de commande (non représenté) recevant le résultat de la comparaison réalisée par le comparateur 206.

Ainsi, lorsque la puissance moyenne, sur la durée de référence, du signal numérique, calculée par le module 204, est inférieure au seuil de puissance, le commutateur 210 est dans la première position : le signal numérique provenant du CPU 104 n'est pas injecté dans le réducteur de puissance 210. La puissance instantanée du signal numérique n'est pas réduite.

Lorsque la puissance moyenne, sur la durée définie, du signal numérique, calculée par le module 204, atteint le seuil puissance, le commutateur 210 est commandé pour passer dans la deuxième position, telle que représentée sur la FIGURE 2. Le signal numérique reçu par le composant 110 est dirigé vers le réducteur de puissance 208 qui applique un gain G de valeur inférieure à 1 pour réduire la puissance instantanée dudit signal numérique. Le signal numérique, dont la puissance instantanée a été réduite, est communiqué par le composant 110 au CNA 106.

Suivant des modes de réalisation, la réduction de puissance est réalisée pendant une durée, dite durée de temporisation. Dans ce cas, le commutateur 210 est maintenue dans la deuxième position pendant ladite durée de temporisation, puis est rebasculé dans la première position après que la durée de temporisation est écoulée.

Comme indiqué plus haut, le seuil de puissance dépend de l'amplificateur de puissance et est configurable.

De plus, la valeur du gain G appliqué par le réducteur de puissance 208 dépend de la puissance instantanée du signal numérique et du seuil de puissance. La valeur du gain G est aussi programmable.

Suivant un exemple de réalisation non limitatif, la valeur du gain peut être calculée selon la relation suivante :

$$G = SP\ /\ \text{maximum de la puissance instantanée}$$

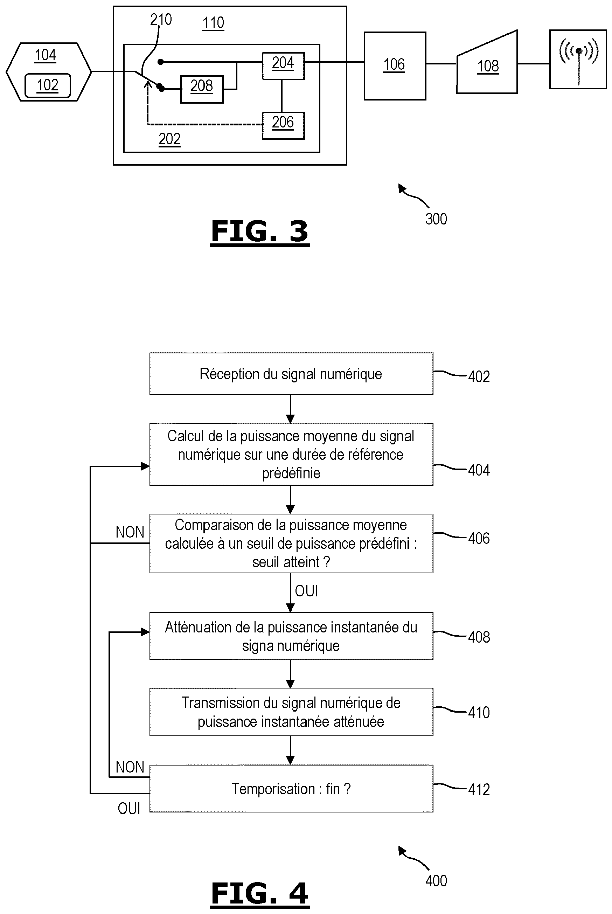

La FIGURE 3 est une représentation schématique d'un autre exemple de réalisation non limitatif d'une radio logicielle selon l'invention.

La radio logicielle 300 représentée sur la FIGURE 3 comprend tous les éléments de la radio logicielle 200 de la FIGURE 2.

La radio logicielle 300 diffère de la radio logicielle 200 en ce que le module 204 de calcul de la puissance moyenne du signal numérique se trouve du côté de la sortie du composant 110, c'est-à-dire en aval du commutateur 210 et/ou du réducteur de puissance 208. En d'autres termes, le module 204 se trouve sur la sortie de l'unité de protection 202. Dans cette position, le module 202 peut déterminer la puissance du signal numérique sortant du composant 110. Ainsi, le module 202 peut surveiller la puissance moyenne du signal numérique avec ou sans réduction de puissance, et surtout, après réduction de sa puissance instantanée, le cas échéant.

Ainsi, il est possible de mieux contrôler la puissance moyenne du signal fourni au CNA 106. De plus, il est possible de s'assurer que la réduction de puissance appliquée par le réducteur de puissance 208 est suffisante.

La FIGURE 4 est une représentation schématique d'un autre exemple de réalisation non limitatif d'un procédé selon l'invention.

Le procédé 400, représenté sur la FIGURE 4, peut être mis en oeuvre dans une radio logicielle selon l'invention, et en particulier dans l'une quelconque des radios logicielles 200 ou 300.

Selon l'invention, le procédé 400 est mise en oeuvre dans l'interface physique entre le processeur, CPU, de la radio logicielle et le convertisseur numérique-analogique, CNA, de la radio logicielle.

Le procédé 400 comprend une étape 402 de réception du signal numérique, i.e. des données numériques, provenant du CPU de la radio logicielle. Le signal numérique représente les données produites par le logiciel exécuté par le CPU. Le signal numérique peut en particulier être un flux de données numériques.

Lors d'une étape 404 la puissance moyenne du signal numérique, sur une durée de référence prédéterminée, est calculée.

Lors d'une étape 406 la puissance moyenne calculée à l'étape 404 est comparée à un seuil de puissance prédéfini. Lorsque la puissance moyenne du signal numérique est inférieure au seuil de puissance, aucune action n'est entreprise. Le procédé reprend à l'étape 404 avec les nouvelles données, i.e. le nouveau signal numérique, reçu(es).

Lorsque la puissance moyenne du signal numérique, calculée à l'étape 404, atteint le seuil de puissance, alors lors d'une étape 408, la puissance instantanée du signal numérique est atténuée, par exemple en appliquant un gain de valeur inférieure à 1 dans un atténuateur.

Lors d'une étape 410, le signal numérique dont la puissance instantanée à été diminuée est transmise au CNA.

Suivant une alternative non représentée, le procédé 400 peut ensuite reprendre à l'étape 404 avec les nouvelles données reçues.

Dans l'exemple représenté sur la FIGURE 4, l'étape 410 est réalisée pendant une durée de temporisation qui est décomptée lors d'une étape 412, Tant que la durée de temporisation n'est pas terminée le procédé reprend à l'étape 408 avec les nouvelles données reçues. Lorsque la durée de temporisation est terminée, le procédé 400 reprend à l'étape 404 avec les nouvelles données reçues.

Les étapes du procédé 400 peuvent être réalisées en continue avec les nouvelles données produites par le logiciel de la radio logicielle. Alternativement, les étapes du procédé 400 peuvent être réalisées à une fréquence prédéterminée.

Bien entendu l'invention n'est pas limitée aux exemples qui viennent d'être décrits.

**Revendications**

1. Radio logicielle (200;300) comprenant :

   - au moins un processeur (104) exécutant un logiciel (102) produisant un signal numérique représentant un flux de données à émettre,
   - un convertisseur numérique-analogique, CNA, (106) pour convertir ledit signal numérique en un signal analogique,
   - une interface physique (110) entre ledit au moins un processeur (104) et ledit CNA, et
   - un amplificateur de puissance radiofréquence (108) pour amplifier la puissance dudit signal analogique ;

   ladite radio logicielle (200;300) comprenant en outre, agencée dans ladite interface physique (110), une unité (202) de protection dudit amplificateur de puissance (108) en fonction :

   - de la puissance moyenne, sur une durée de référence prédéfinie, du signal numérique reçu par ladite interface physique (110),
   - d'un seuil de puissance prédéfini à ne pas dépasser pendant ladite durée.

2. Radio (200;300) selon la revendication précédente, **caractérisée en ce que** l'unité de protection (202) comprend :

   - un module (204) de calcul de la puissance moyenne, sur la durée de référence, du signal numérique reçu par l'interface physique,
   - un comparateur (206) comparant ladite puissance moyenne calculée au seuil de puissance, et
   - un étage (208,210)) de modification de la puissance instantanée du signal numérique fourni au CNA, lorsque ladite puissance moyenne atteint ledit seuil de puissance.

3. Radio (200;300) selon la revendication précédente, **caractérisée en ce que** l'étage (208,210) de modification comprend un moyen arrêtant la fourniture du signal numérique au CNA.

4. Radio (200;300) selon la revendication 2, **caractérisée en ce que** l'étage (208,210) de modification comprend un réducteur (208), ou un diviseur, pour réduire la puissance du signal numérique reçu en entrée de l'interface physique (110).

5. Radio (200;300) selon l'une quelconque des revendications précédentes, **caractérisée en ce que** l'interface physique (110) comprend, ou est, un FPGA (« Field-programmable gate array » ou « Réseau de portes programmables in situ ») ou ASIC (« Application Specific Integrated Circuit »).

**6.** Appareil électronique comprenant une radio logicielle (200;300) selon l'une quelconque des revendications précédentes.

**7.** Appareil selon la revendication précédente, **caractérisée en ce qu'**il s'agit d'un émetteur Wifi, d'un émetteur Bluetooth®, un émetteur radio numérique terrestre (DAB pour « Digital Audio Broadcasting »), un émetteur radio numérique mobile (DMR pour « Digital Mobile radio »).

**8.** Procédé (400) de protection d'une radio logicielle (200;300), ladite radio logicielle (200;300) comprenant :

- au moins un processeur (104) exécutant un logiciel (102) produisant un signal numérique représentant un flux de données à émettre,
- un convertisseur numérique-analogique, CNA, (106) pour convertir ledit signal numérique en un signal analogique,
- une interface physique (110) entre ledit au moins un processeur (104) et ledit CNA (106), et
- un amplificateur de puissance (108) radiofréquence pour amplifier la puissance dudit signal analogique fourni par le CNA;

ledit procédé (400) comprenant une exécution, au sein de ladite interface physique (110), d'une fonction de protection dudit amplificateur de puissance (108) comprenant les étapes suivantes :

- calcul (404) de la puissance moyenne, sur une durée de référence prédéfinie, du signal numérique reçu par ladite interface physique,
- comparaison (406) de ladite puissance à un seuil de puissance prédéfini à ne pas dépasser pendant ladite durée de référence, et
- lorsque ladite puissance moyenne atteint le seuil de puissance limite, diminution (406) de la puissance instantanée du signal numérique fourni au CNA.

**9.** Procédé (400) selon la revendication précédente, **caractérisée en ce que** l'étape (406) de diminution de la puissance est réalisée pendant une durée prédéterminée, dite durée de temporisation.

**10.** Procédé (400) selon l'une quelconque des revendications 8 ou 9, **caractérisée en ce que** l'étape (406) de diminution de la puissance est réalisée par application d'un gain inférieur à 1 au signal numérique reçu en entrée de l'interface physique (110).

**FIG. 1 : Art antérieur**

**FIG. 2**

## FIG. 3

300

```
┌─────────────────────────────────────┐
│    Réception du signal numérique     │──── 402
└─────────────────────────────────────┘
                 │
                 ▼
┌─────────────────────────────────────┐
│  Calcul de la puissance moyenne du   │
│  signal numérique sur une durée de   │──── 404
│     référence prédéfinie             │
└─────────────────────────────────────┘
                 │
        NON      ▼
┌─────────────────────────────────────┐
│  Comparaison de la puissance moyenne │
│  calculée à un seuil de puissance    │──── 406
│   prédéfini : seuil atteint ?        │
└─────────────────────────────────────┘
                 │ OUI
                 ▼
┌─────────────────────────────────────┐
│ Atténuation de la puissance          │
│ instantanée du signa numérique       │──── 408
└─────────────────────────────────────┘
                 │
                 ▼
┌─────────────────────────────────────┐
│ Transmission du signal numérique de  │
│ puissance instantanée atténuée       │──── 410
└─────────────────────────────────────┘
                 │
        NON      ▼
┌─────────────────────────────────────┐
│         Temporisation : fin ?        │──── 412
└─────────────────────────────────────┘
        OUI
```

400

## FIG. 4

**Europäisches Patentamt**
**European Patent Office**
**Office européen des brevets**

# RAPPORT DE RECHERCHE EUROPEENNE

Numéro de la demande

EP 23 30 6274

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | WO 2019/080566 A1 (COMBA TELECOM SYSTEMS CHINA LTD [CN] ET AL.) 2 mai 2019 (2019-05-02) * page 7, ligne 25 – page 9, ligne 26; figure 1 * ----- | 1-10 | INV. H04B1/04 |
| A | WO 2010/000184 A1 (HUAWEI TECH CO LTD [CN]; LIU YE [CN] ET AL.) 7 janvier 2010 (2010-01-07) * abrégé * ----- | 1-10 | |

**DOMAINES TECHNIQUES RECHERCHES (IPC)**

H04B

Le présent rapport a été établi pour toutes les revendications

| Lieu de la recherche | Date d'achèvement de la recherche | Examinateur |
|---|---|---|
| Munich | 16 janvier 2024 | Marques, Gabriela |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons
................................................
& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 23 30 6274

La présente annexe indique les membres de la famille de brevets relatifs aux documents  brevets cités dans le rapport de
recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

16-01-2024

| Document brevet cité au rapport de recherche | Date de publication | Membre(s) de la famille de brevet(s) | Date de publication |
|---|---|---|---|
| WO 2019080566 A1 | 02-05-2019 | CN 107612588 A<br>WO 2019080566 A1 | 19-01-2018<br>02-05-2019 |
| WO 2010000184 A1 | 07-01-2010 | CN 101316128 A<br>WO 2010000184 A1 | 03-12-2008<br>07-01-2010 |

EPO FORM P0460

Pour tout renseignement concernant cette annexe : voir Journal Officiel de l'Office européen des brevets, No.12/82